# FASCICULE DE BREVET EUROPEEN

(11) **EP 0 514 297 B1**
(45) Date de publication et mention de la délivrance du brevet: **18.12.1996**
(21) Numéro de dépôt: 92420155.1
(22) Date de dépôt: 13.05.1992
(51) Int. Cl.: H01L 29/40, H01L 21/288

(54) **Procédé de prise de contact sur un composant semiconducteur**
Verfahren zum Herstellen eines Kontakts auf einem Halbleiterbauelement
Process for making a contact to a semiconductor device

(30) Priorité: 17.05.1991 FR 9106347
(43) Date de publication de la demande: 19.11.1992
(73) Titulaire: SGS-THOMSON MICROELECTRONICS S.A., 94250 Gentilly (FR)
(72) Inventeur: Anceau, Christine, F-37390 Saint Roch (FR); Quoirin, Jean-Baptiste, F-37100 Tours (FR)
(74) Mandataire: de Beaumont, Michel

(56) Documents cités:
- FR-A- 2 500 855
- US-A- 3 982 908
- US-A- 4 321 283
- PATENT ABSTRACTS OF JAPAN vol. 011, no. 033 (E-476) 30 Janvier 1987 & JP-A-61 202 429 (NEC CORP) 8 Septembre 1986

## Description

La présente invention concerne la prise de contact sur des composants semiconducteurs et plus particulièrement sur des composants semiconducteurs discrets tels que des diodes ou des doubles diodes de type planar.

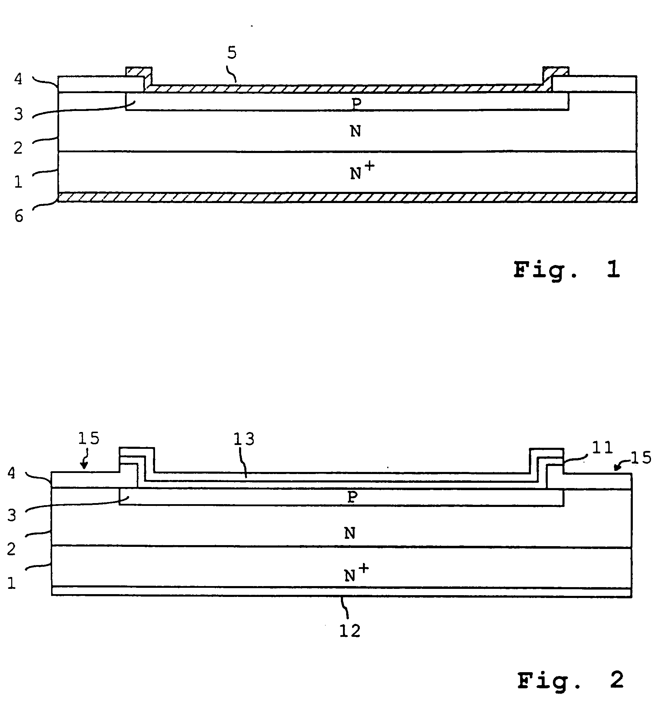

La figure 1 représente une structure classique de diode planar. Cette diode comprend un substrat constitué d'une couche inférieure 1 du type N⁺ et d'une couche supérieure 2 de type N. La diode est constituée par la jonction entre une région 3 de type P et la région 2. Cette diode est de type planar, c'est-à-dire que la région de type P est formée à travers une ouverture dans une couche d'oxyde de silicium 4 formée au-dessus de la région 2 de type N. Une métallisation 5 permet de prendre un contact sur la face supérieure et une métallisation 6 de prendre un contact sur la face inférieure. La métallisation 6 s'étend classiquement sur toute la face inférieure. Par contre, la métallisation 5 doit être délimitée et ne pas s'étendre jusqu'aux limites de la diode. En effet, la diode représentée fait partie lors de sa fabrication d'une plaquette comprenant un grand nombre de puces de diodes identiques. Si la métallisation 5 s'étendait jusqu'au bord de la puce individuelle, il y aurait un risque, lors du sciage, pour que des particules de la métallisation entraînent un court-circuit latéral entre la métallisation 5 et le bord de la couche 2 de type N. De plus, dans une diode de type planar, il faut que les lignes de champ puissent remonter vers la surface recouverte de la couche de SiO₂. Si la métallisation s'étendait jusqu'au bord, elle aurait un effet de plaque de champ et les lignes de champ se termineraient sur les bords latéraux de la diode et l'on retrouverait les problèmes de passivation latérale qui se posent avec les diodes de type mésa.

Classiquement, les métallisations 5 et 6 sont obtenues par évaporation ou pulvérisation cathodique de métaux successifs, par exemple le aluminium/nickel/or. Ensuite, cette métallisation est soudée par des préformes de soudure non représentées à des cosses de liaison non représentées. Ainsi, on procède à une pulvérisation sur toute la plaquette de silicium d'un système tricouche aluminium/nickel/or puis on élimine une partie de la couche supérieure 5 par photolithogravure. Un inconvénient de cette technique est qu'une partie importante, typiquement de 40 à 50% de la surface de la couche supérieure, doit être éliminée. Cette couche comprenant un matériau noble tel que de l'or, ce gaspillage d'or représente un coût non négligeable, d'autant plus qu'on ne sait généralement pas récupérer l'or dissous dans les produits de gravure. On notera que, dans un sandwich aluminium/nickel/or, la couche essentielle pour la brasure est la couche de nickel. La couche d'aluminium est prévue pour servir de barrière à l'encontre de la diffusion éventuelle du nickel dans la couche 3 de type P, ce qui pourrait conduire à un perçage de la diode. En outre, l'aluminium permet un bon contact sur le silicium. La couche d'or est destinée à éviter l'oxydation de la couche de nickel dans l'attente de la phase de brasure.

Pour éviter le gaspillage de métal susmentionné, l'abrégé de brevet japonais JP-A-61/202 429 (Patent Abstracts of Japan, vol. 11, N° 33) décrit un procédé de prise de contact sur une face d'une puce semiconductrice comportant une région diffusée délimitée par une couche de masquage isolante, comprenant les étapes consistant à former une couche de silicium polycristallin dopé selon le même type de conductivité que la région diffusée, à délimiter cette couche pour qu'elle recouvre la région diffusée et déborde au-dessus de la périphérie intérieure dudit masque; et à immerger la plaquette dans un bain de dépôt électrolytique d'un métal de sorte que du métal se dépose sur les surfaces conductrices de la plaquette.

Il apparaît que les composants réalisés selon ce procédé présentent une mauvaise fiabilité et que leurs caractéristiques dérivent au cours du temps.

Un objet de la présente invention est de pallier cet inconvénient.

Un autre objet de la présente invention est de permettre le dépôt de plusieurs couches de métallisation.

Ainsi, pour remédier aux inconvénients des diverses techniques connues de métallisation, la présente invention propose un procédé de prise de contact sur une face d'une puce semiconductrice comportant une région diffusée délimitée par une couche de masquage isolante, cette puce faisant partie d'une plaquette semiconductrice. Ce procédé comprend les étapes suivantes :
a) former une couche de silicium polycristallin dopé selon le même type de conductivité que la région diffusée et délimiter cette couche pour qu'elle recouvre la région diffusée et déborde au-dessus de la périphérie intérieure dudit masque ;
b) immerger la plaquette dans au moins un bain de dépôt chimique d'un métal de sorte que du métal se dépose sur les surfaces conductrices de la plaquette ; et
c) après chaque passage dans un bain de dépôt, immerger la plaquette dans au moins un bain de gravure sélective du masque isolant pour décaper une partie de ce masque.

Selon un mode de réalisation de la présente invention, l'étape b) comprend une immersion dans un bain de dépôt chimique de nickel suivie d'une immersion dans un bain de dépôt chimique d'or, chaque immersion étant suivie d'une étape de décapage.

Selon un mode de réalisation de la présente invention, chaque passage dans un bain de dépôt de nickel puis dans un bain de décapage est suivi d'un recuit de la métallisation de nickel.

Selon un mode de réalisation de la présente invention, la couche de silicium polycristallin dopé sert de source de diffusion pour la formation de ladite région diffusée.

Selon une application de la présente invention, la puce constitue une diode.

Selon une application de la présente invention, la puce constitue une double diode.

Ces objets, caractéristiques et avantages ainsi que d'autres de la présente invention seront exposés en détail dans la description suivante de modes de réalisation particuliers faite en relation avec les figures jointes parmi lesquelles :
la figure 1 illustre une structure de diode de l'art antérieur ; et
la figure 2 illustre une structure de prise de contact sur une diode selon la présente invention.

On notera que dans ces figures, comme cela est usuel dans le domaine de la représentation des composants semiconducteurs, les diverses couches et régions ne sont pas tracées à l'échelle pour faciliter la lisibilité des figures. Les dimensions seront déterminées classiquement par l'homme de l'art sauf indications particulières dans la description ci-après.

La figure 2 représente une structure de diode comprenant un substrat N⁺N 1,2 et une région 3 de type P formée à l'intérieur d'un masque d'oxyde 4. La métallisation de face supérieure est formée en déposant d'abord une couche de silicium polycristallin 11, dopée de type P pour présenter un bon contact ohmique avec la région 3. La couche 11 de silicium polycristallin est gravée selon un contour choisi, correspondant sensiblement à celui de la métallisation 5 de la figure 1. On trempe ensuite la plaquette dans un bain chimique de dépôt métallique pour former une métallisation de face inférieure 12 et une métallisation de face supérieure 13. Comme cela est connu, lors de ce dépôt en bain chimique, le métal se dépose seulement sur les régions conductrices à savoir sur la face inférieure de la puce et sur la région de silicium polycristallin 11.

La description qui précède et les figures traitent d'une seule puce. En pratique, lors des étapes décrites ici, cette puce fait partie d'une plaquette sur laquelle sont simultanément réalisées de nombreuses puces identiques qui sont séparées seulement lors d'une étape finale de fabrication.

De préférence, les métallisations 12 et 13 sont constituées par des dépôts successifs de nickel et d'or, le nickel étant déposé par exemple à partir d'un bain constitué d'une saumure de chlorure de nickel et d'hypophosphite de sodium tandis que l'or est déposé à partir d'un bain d'aurocyanure de potassium.

Après passage dans le bain de nickel, on procède selon l'invention à un décapage superficiel de la couche d'oxyde apparente. Cette opération permet d'éliminer la partie supérieure 15 de la couche d'oxyde. En effet la demanderesse a constaté que les opérations de rinçage usuelles ne sont pas suffisantes et que des ions polluants, notamment des ions alcalins tels que des ions sodium, s'incrustent dans la couche d'oxyde pendant l'étape de dépôt chimique. En l'absence de l'opération de décapage selon l'invention, ces ions alcalins incrustés lors du passage dans le bain de nickel pénètrent ultérieurement profondément dans la couche d'oxyde et y introduisent des charges positives qui rendent les caractéristiques de la jonction sous-jacente instables et évolutives. Cette pénétration est d'autant plus importante que l'on procède, après dépôt du nickel, à un recuit à une température élevée, par exemple 600°C, pour assurer une meilleure adhérence du métal. Eventuellement, pour obtenir une couche de nickel d'épaisseur souhaitée, on procède à plusieurs passages dans le bain de dépôt de nickel, chaque passage étant suivi d'un décapage et d'un recuit.

Cette opération de décapage est de préférence répétée après passage dans le bain d'or. Par contre, il n'est généralement pas procédé à un recuit après le dépôt de la couche d'or qui est seulement destinée à éviter l'oxydation de la couche de nickel.

A titre d'exemple de valeurs numériques, on notera qu'une diode telle que celle de la figure 2 peut être une puce carrée ayant des dimensions de 1 à 3 mm de côté. Si cette puce a un côté de 1,6 mm, la région P pourra être un carré de 1,3 mm de côté. La couche d'oxyde 4 pourra avoir une épaisseur de 2 micromètres, la couche de silicium polycristallin une épaisseur de 250 nm, et la métallisation nickel/or une épaisseur de l'ordre de 600 nm.

D'autre part, la présente invention a été décrite uniquement dans le cadre de la réalisation d'une diode. L'homme de l'art notera qu'elle pourra s'appliquer à d'autres composants, par exemple une structure symétrique de double diode où le même dépôt polycristallin est répété sur les deux faces. De même, les types de conductivité décrits pourraient être inversés.

De plus, on pourra envisager d'autres types de métallisations que ceux qui ont été spécifiquement décrits ici et des bains de dépôt chimique appropriés.

Par ailleurs, on a indiqué précédemment que la région 3 de type P était formée avant le dépôt de la couche de silicium polycristallin 11. L'homme de l'art notera que cette diffusion P peut être obtenue par recuit à partir d'atomes dopants contenus dans le silicium polycristallin dopé 11. C'est d'ailleurs la solution qui est préférée car le silicium polycristallin fortement dopé joue alors, pendant la phase de recuit, un rôle de piège (getter) pour les impuretés métalliques parasités se trouvant dans la région 2 de type N.

## Revendications

1. Procédé de prise de contact sur une face d'une puce semiconductrice comportant une région diffusée (3) délimitée par une couche isolante formant masque (4), cette puce faisant partie d'une plaquette semiconductrice, comprenant les étapes suivantes :
a) former une couche (11) de silicium polycristallin dopé selon le même type de conductivité que la région diffusée et délimiter cette couche pour qu'elle recouvre la région diffusée et déborde au-dessus de la périphérie intérieure dudit masque ; et
b) immerger la plaquette dans au moins un bain de dépôt chimique d'un métal de sorte que du métal (12, 13) se dépose sur les surfaces conductrices de la plaquette ; caractérisé en outre en ce qu'il comprend l'étape suivante :
c) après chaque immersion dans un bain de dépôt, immerger la plaquette dans au moins un bain de gravure sélective du masque isolant pour décaper une partie de l'épaisseur de ce masque.

2. Procédé selon la revendication 1, caractérisé en ce que l'étape b) comprend une immersion dans au moins un bain de dépôt chimique de nickel suivie d'une immersion dans un bain de dépôt chimique d'or.

3. Procédé selon la revendication 2, caractérisé en ce que chaque étape d'immersion dans un bain de dépôt de nickel puis dans un bain de décapage est suivie d'un recuit.

4. Procédé selon la revendication 1, caractérisé en ce que le masque isolant est de l'oxyde de silicium.

5. Procédé selon la revendication 1, caractérisé en ce que ladite couche de silicium polycristallin dopé sert de source de diffusion pour la formation de ladite région diffusée.

6. Procédé selon la revendication 1, caractérisé en ce que ladite puce constitue une diode.

7. Procédé selon la revendication 1, caractérisé en ce que ladite puce constitue une double diode.

## Patentansprüche

1. Verfahren zur Bildung eines Metallkontaktes auf einer Oberfläche eines Halbleiterchips, der eine Diffusionszone (3) aufweist, und zwar begrenzt durch eine eine Maske (4) bildende Isolierschicht, wobei der Chip Teil eines Halbleiterwafers ist und wobei folgende Schritte vorgesehen sind:
(a) Ausbilden einer dotierten polykristallien Siliziumschicht (11) auf dem Wafer, und zwar dotiert gemäß dem gleichen Leitfähigkeitstyps wie die Diffusionszone und Begrenzen der polykristallien Siliziumschicht derart, daß sie die Diffusionszone abdeckt und die Innenumfangsoberflächen der Maske überlappt;
(b) Eintauchen des Wafers in mindestens ein chemisches Metallabscheidungsbad derart, daß sich Metall (12, 13) auf den leitenden Oberflächen des Wafers abscheidet;
dadurch gekennzeichnet, daß außerdem der folgende Schritt vorgesehen ist:
(c) nach jedem Eintauchen in ein Abscheidungsbad wird der Wafer in mindestens ein selektives Gravurbad für die isolierende Maske eingetaucht, um einen Teil der Dicke der Maske wegzuätzen.

2. Verfahren nach Anspruch 1, wobei der Schritt (b) das Eintauchen in mindestens ein chemisches Nickel-Abscheidungsbad aufweist, und zwar gefolgt von einem Eintauchen in ein chemisches Gold-Abscheidungsbad.

3. Verfahren nach Anspruch 2, dadurch gekennzeichnet, daß jedem Eintauchschritt in ein Nickel-Abscheidungsbad und dann in ein Ätzbad gefolgt ist von einer Anlassung.

4. Verfahren nach Anspruch 1, dadurch gekennzeichnet, daß die Isoliermaske aus Siliziumoxyd besteht.

5. Verfahren nach Anspruch 1, dadurch gekennzeichnet, daß die dotierte polykristallien Siliziumschicht als eine Diffusionsquelle für die Bildung der erwähnten diffundierten Zone verwendet wird.

6. Verfahen nach Anspruch 1, dadurch gekennzeichnet, daß der erwähnte Chip eine Diode bildet.

7. verfahren nach Anspruch 1, dadurch gekennzeichnet, daß der erwähnte Chip eine Doppel-Diode bildet.

## Claims

1. A method of forming a metal contact on a surface of a semiconductor chip comprising a diffusion region (3) delineated by an isolating layer forming a mask (4), said chip being part of a semiconductor wafer, comprising the steps of:
(a) forming a polysilicon layer (11) doped according to the same conductivity type as the diffused region on said wafer and delineating said polysilicon layer so that it covers the diffused region and overlaps the internal peripheral surfaces of said mask;
(b) immersing said wafer in a metal-plating electroless bath to deposit a metallization layer (12, 13) on conductive surfaces of said wafer including said polysilicon layer; and
(c) after each metal-plating, immersing said wafer in a selective etching bath for partially etching away said mask.

2. The method according to claim 1, wherein step (b) comprises immersing said semiconductor chip in at least one nickel-plating electroless bath followed by immersing in a gold-plating electroless bath.

3. The method according to claim 2, wherein each immersion in a nickel-plating bath, and then in an etching bath, is followed by an annealing step.

4. A method according to claim 1, wherein the isolating mask is silicon oxide.

5. A method according to claim 1, wherein said doped polysilicon layer is used as a diffusion source for forming said diffused region.

6. A method according to claim 1, wherein said chip constitutes a diode.

7. A method according to claim 1, wherein said chip constitutes a double diode.
